## Europäisches Patentamt

## European Patent Office

## Office européen des brevets

(19)

(11) Veröffentlichungsnummer: **0 027 881**
**B1**

(12)

# EUROPÄISCHE PATENTSCHRIFT

(45) Veröffentlichungstag der Patentschrift:
17.08.83

(51) Int. Cl.³: **H 04 N 3/14, H 01 L 29/94**

(21) Anmeldenummer: **80105482.6**

(22) Anmeldetag: **12.09.80**

(54) **Monolithisch integrierter, zweidimensionaler Bildsensor mit einer differenzbildenden Stufe und Verfahren zu dessen Betrieb.**

(30) Priorität: **28.09.79 DE 2939490**

(43) Veröffentlichungstag der Anmeldung:
**06.05.81 Patentblatt 81/18**

(45) Bekanntmachung des Hinweises auf die Patenterteilung:
**17.08.83 Patentblatt 83/33**

(84) Benannte Vertragsstaaten:
**BE FR GB IT NL**

(56) Entgegenhaltungen:
**DE-A-2 344 513**
**DE-A-2 611 771**
**DE-A-2 811 146**
**DE-B-2 527 626**
**DE-B-2 652 709**
**US-A-3 876 952**
**US-A-3 949 162**
**US-A-4 145 721**

(73) Patentinhaber: **SIEMENS AKTIENGESELLSCHAFT,
Berlin und München Wittelsbacherplatz 2,
D-8000 München 2 (DE)**

(72) Erfinder: **Endlicher, Frank, Dipl.-Phys., Plievierpark 10,
D-8000 München 83 (DE)**
Erfinder: **Koch, Rudolf, Dipl.-Ing., Nimrodstrasse 42,
D-8034 Germering (DE)**

Monolithisch integrierter zweidimensionaler Bildsensor mit einer differenzbildenden Stufe und Verfahren zu dessen Betrieb

Die Erfindung bezieht sich auf einen monolithisch integrierten zweidimensionalen Bildsensor nach dem Oberbegriff des Anspruchs 1.

Eine solche integrierte Schaltung ist aus der DE-PS 2 611 771 bekannt. Die differenzbildende Stufe ist dort als eine Schaltungsstufe angegeben, die eine doppelte Abtastung der über eine Auslesevorrichtung von den gestörten Sensorsignalen einerseits und den Nullsignalen andererseits abgeleiteten Spannungssignale durchgeführt. Eine solche Schaltungsstufe erfordert einen relativ großen Schaltungsaufwand und läßt sich nur schwer auf dem Halbleiterkörper mitintegrieren.

Der Erfindung liegt die Aufgabe zugrunde, bei einem monolithisch integrierten Bildsensor der eingangs genannten Art die erwähnten Schwierigkeiten zu beheben. Diese Aufgabe wird durch die im Anspruch 1 gekennzeichneten Merkmale gelöst.

Aus der DE-OS 2 811 146 ist ein auf einem Halbleiterkörper integrierter Schaltkreis zur Differenzbildung von elektrischen Ladungen bekannt, bei dem die zu messenden Ladungen in einer ladungsgekoppelten Anordnung nacheinander in die durch eine Elektrode mit frei einstellbarem Potential und dem Halbleiterkörper gebildete Kapazität gebracht und daraus entfernt werden und die entsprechende Potentialdifferenz an der Elektrode gemessen wird. Eine Anwendung dieses Schaltkreises als Auslesevorrichtung eines zweidimensionalen Bildsensors würde jedoch einen gleichzeitigen Transport von gestörten Sensorsignalen und Nullsignalen bedeuten, was zu einem großen Flächenbedarf der Auslesevorrichtung führen würde.

Der mit der Erfindung erzielbare Vorteil besteht insbesondere darin, daß sie Signalentstörung durch einen in einfacher Weise zu realisierenden, der Auslesevorrichtung vorgeordneten Schaltungsteil erfolgt, der nur einen geringen Mehraufwand an Halbleiterfläche erfordert. Damit kann der zweidimensionale Bildsensor einschließlich der differenzbildenden Stufe und der Auslesevorrichtung auf einer wesentlich kleineren Halbleiterfläche realisiert werden, als dies bei den bekannten Schaltungen der Fall wäre.

Die Erfindung wird nachfolgend anhand der Zeichnung näher erläutert. Dabei zeigt

Fig. 1 einen nach der Erfindung ausgebildeten zweidimensionalen Bildsensor,

Fig. 2 einen Querschnitt durch eine Teilschaltung nach Fig. 1 längs der Linie II-II,

Fig. 3 Spannungs-Zeit-Diagramme zur Erläuterung der Schaltung nach Fig. 1,

Fig. 4 eine weitere Teilschaltung von Fig. 1 und

Fig. 5 eine Alternative zu Fig. 4.

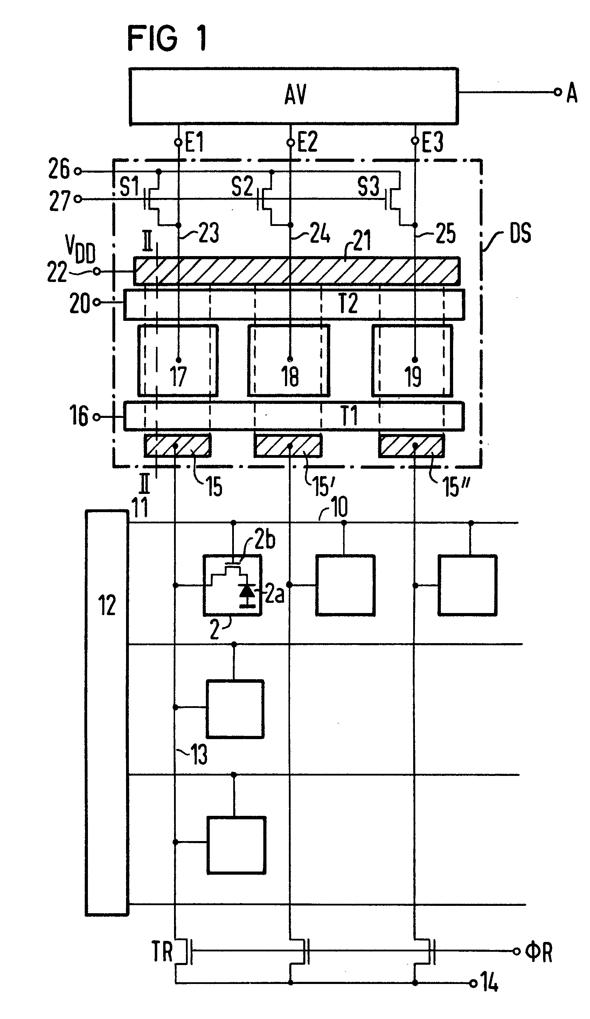

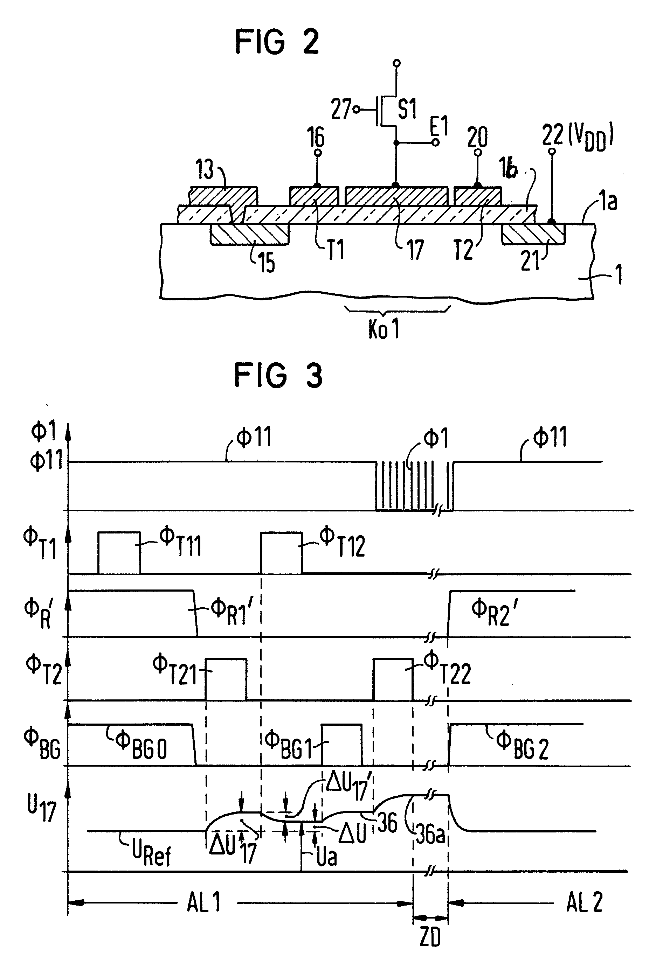

In den Fig. 1 und 2 ist eine Schaltung schematisch dargestellt, bei der ein zweidimensionaler Bildsensor mit der zugehörigen Auslesevorrichtung auf einem dotierten Halbleiterkörper 1, z. B. aus p-leitendem Silizium, monolithisch integriert ist. Aus Gründen einer einfachen Darstellung weist der Bildsensor 2 nur neun Sensorelemente auf, die in drei Zeilen und drei Spalten angeordnet sind. Im allgemeinen enthalten Bildsensoren dieser Art jedoch 100 oder mehr Elemente pro Zeile und Spalte. Die Sensorelemente der ersten Zeile sind mit einer gemeinsamen Zeilenleitung 10 verbunden, die an einen Ausgang 11 eines digitalen Schieberegisters 12 geführt ist. Über den Ausgang 11 sind sämtliche Elemente der ersten Zeile gleichzeitig selektierbar. In analoger Weise sind auch die Sensorelemente der übrigen Zeilen über ihre Zeilenleitungen mit Ausgängen des Schieberegisters 12 verbunden, die den Zeilenleitungen individuell zugeordnet sind.

Für jede Sensorspalte ist eine Spaltenleitung, z. B. 13, vorgesehen, die mit allen Sensorelementen dieser Spalte verbindbar ist und über einen mit einer Taktimpulsspannung $\Phi_R$ beschalteten Transistor TR mit einem Anschluß 14 in Verbindung steht, der auf einem Referenzpotential liegt. Die übrigen Spaltenleitungen sind ebenfalls mit den neben ihnen angeordneten Sensorelementen verbindbar und über eigene Transistoren an den Anschluß 14 geführt. Die Spaltenleitung 13 ist weiterhin mit einem an der Grenzfläche des Halbleiterkörpers 1 vorgesehenen Gebiet 15 verbunden, das eine zu diesem entgegengesetzte Leitfähigkeit besitzt. Der neben dem Gebiet 15 liegende Halbleiterbereich wird durch ein mit einem Anschluß 16 versehenes Transfergate T1 überdeckt, das durch eine dünne elektrisch isolierende Schicht 1b, z. B. aus $SiO_2$, von der Grenzfläche 1a des Halbleiterkörpers 1 getrennt ist. In gleicher Weise sind auch die anderen Spaltenleitungen mit ihnen zugeordneten Halbleitergebieten 15' und 15'' verbunden. Das Gate T1 ist neben allen diesen Gebieten angeordnet.

Die Sensorelemente 2 bestehen z. B. aus Fotodioden 2a, wie in Fig. 1 angedeutet ist. Dabei ist jede Fotodiode über die Source-Drain-Strecke eines Feldeffekttransistors 2b mit der zugehörigen Spaltenleitung 13 verbunden, während das Gate von 2b an der entsprechenden Zeilenleitung liegt. Andererseits können die Sensorelemente 2 auch aus MIS-Kondensatoren oder aus Fotodioden mit diesen benachbarten MIS-Kondensatoren bestehen oder als CID-Sensorelemente ausgebildet sein, die jeweils zwei nebeneinanderliegende MIS-Kondensatoren aufweisen. All diese Arten von Sensorelementen sind an sich bekannt, so z. B. aus dem Buch von P. G. Jespers »Solid State Imaging«, Noordhof Int. Publishing, Leyden, Niederlande, Seiten 447 bis 461, und der Veröffentlichung von S. Ohba »A 1024 element linear CCD and sensor with a new photodiode structure«, Procedings IEDM 1977, Washington, Seiten 538 bis 541. Werden Fotodioden als Sensoren verwendet, so ergibt sich der Vorteil einer gleichmäßigen spektralen Empfindlichkeit.

Neben dem Transfergate T1 befinden sich äußere Elektroden 17 bis 19 von MIS-Kondensatoren Ko1 bis Ko3. Unter »MIS« wird dabei eine Struktur verstanden, die aus einer leitenden Schicht und einer Halbleiterschicht besteht, die durch eine dünne elektrisch isolierende Schicht voneinander getrennt sind. Auf der von T1 abgewandten Seite der MIS-Kondensatoren ist ein mit einem Anschluß 20 versehenes Transfergate T2 angeordnet, das ebenfalls durch die isolierende Schicht 1b von der Grenzfläche 1a getrennt ist. An dieses schließt sich in lateraler Richtung ein Halbleitergebiet 21 an, das eine zu dem Halbleiterkörper 1 entgegengesetzte Leitfähigkeit aufweist und mit einem an einer Betriebsspannung $V_{DD}$ liegenden Anschluß 22 verbunden ist. Die Elektroden 17 bis 19 sind über jeweils eigene Verbindungsleitungen 23 bis 25 mit den Eingängen E1 bis E3 einer Auslesevorrichtung AV verbunden, die so ausgebildet ist, daß an E1 bis E3 anliegende Signale sequentiell an einem Ausgang A ausgegeben werden.

Die Elektroden 17 bis 19 sind weiterhin mit Rücksetzvorrichtungen verbunden, die ein Rücksetzen derselben auf eine Referenzspannung $U_{Ref}$ sowie eine Freischaltung der Elektroden 17 bis 19 von äußeren Potentialen, also einen Zustand des »floating«, ermöglichen. Die in Fig. 1 dargestellten Rücksetzvorrichtungen bestehen aus Feldeffekttransistoren S1 bis S3, über deren Source-Drain-Strecken die Elektroden 17 bis 19 an einen gemeinsamen Anschluß 26 geführt sind, der mit $U_{Ref}$ beschaltet ist, während ihre Gates an einen gemeinsamen, mit einer Taktimpulsspannung $\Phi_R{}'$ beschalteten Anschluß 27 geführt sind. Die Anschlüsse 16 und 20 sind mit Taktimpulsspannungen $\Phi_{T1}$ und $\Phi_{T2}$ beschaltet. Der in Fig. 1 mit DS bezeichnete Schaltungsteil stellt eine differenzbildende Stufe dar.

Das Auslesen von Bildinformationen beginnt zunächst mit einem Rücksetzen der Spaltenleitungen einer Zeile auf das Referenzpotential $V_R$. Zu diesem Zweck werden die Transistoren TR in den leitenden Zustand geschaltet. Anschließend werden Transistoren TR wieder gesperrt, so daß die Spaltenleitungen von äußeren Potentialen freigeschaltet sind, d. h. sich im Zustand des »floating« befinden. Dann werden die Transistoren 2b einer Zeile über die zugehörige Zeilenleitung 10 leitend geschaltet. Nun fließen die in den Sensorelementen gesammelten, optisch erzeugten Ladungsträger auf die Spaltenleitung, die dadurch eine Potentialänderung erfährt. Anschließend werden die Transistoren 2b wieder gesperrt.

Betrachtet man nunmehr die Vorgänge bei der in der Zeitspanne AL1 erfolgenden Auslesung des an der Zeilenleitung 10 und der Spaltenleitung 13 liegenden Sensorelements 2 in Verbindung mit Fig. 3, so wird ein erstes Ladungspaket Q1, das von der genannten Potentialänderung auf der Spaltenleitung 13 herrührt, aus dem Gebiet 15 über den Halbleiterbereich unterhalb des mit einem Taktimpuls $\Phi_{T11}$ belegten Transfergate T1 in den Kondensator Ko1 übertragen.

Die Spannung $U_{17}$ der Elektrode 17 wird bei der Zuführung von Q1 wegen des an 27 liegenden Taktimpulses $\Phi_{R1}{}'$ auf dem Wert $U_{Ref}$ gehalten. Nach dem Abschalten von $\Phi_{R1}{}'$ wird Q1 durch Anlegen eines Taktimpulses $\Phi_{T21}$ an den Anschluß 20 in das Halbleitergebiet 21 abgeleitet. Dabei erhöht sich die Spannung $U_{17}$ um einen Betrag $\Delta U_{17}$ (Fig. 3).

Anschließend werden die gleichen Sensorelemente, also im betrachteten Fall die an der Zeilenleitung 10 liegenden, einem zweiten Auslesevorgang unterzogen, wobei der Unterschied zu dem ersten Auslesevorgang darin besteht, daß möglichst wenig optisch erzeugte Ladungsträger in den Sensorelementen gesammelt werden. Das kann z. B. durch eine sehr kurze Bemessung der Zeit zwischen dem ersten und zweiten Auslesevorgang geschehen. Die hierbei noch erhaltenen Signale sind ausschließlich auf störende Einflüsse innerhalb des Bildsensors zurückzuführen, wie z. B. auf Kennwertedifferenzen einzelner Teilschaltungen gegeneinander, auf Einkopplungen der zum Betrieb verwendeten Taktimpulsspannungen usw. Derartige Störungen werden auch als »fixed pattern noise« bezeichnet. Die hiervon herrührenden Ladungen werden nun in der beschriebenen Weise in Ladungspakete Q2 umgesetzt, die beim Auftreten von $\Phi_{T12}$ in den Kondensator Ko1 übertragen werden.

Die Ladungen Q1 entsprechen den durch die Störungen bzw. Störsignale beeinflußten Sensorsignalen, während die Ladungspakete Q2 den Störungen allein entsprechen und daher auch als Nullsignalladungen bezeichnet werden.

Beim Einbringen der Ladung Q2 in den Halbleiterbereich unterhalb der Elektrode 17 tritt an dieser eine Spannungsabsenkung $\Delta U_{17}{}'$ auf. Damit ergibt sich eine Spannung $U_a$ auf der Verbindungsleitung 23, deren Differenz $\Delta U$ gegenüber $U_{Ref}$ der Differenz aus der Sensorsignalladung Q1 und der Nullsignalladung Q2 und damit dem ungestörten bzw. korrigierten Sensorsignal entspricht.

Das korrigierte Sensorsignal wird über den Eingang E1 der Auslesevorrichtung AV zugeführt und in einer vorgegebenen zeitlichen Folge mit den an den anderen Eingängen E2 und E3 anliegenden, korrigierten Sensorsignalen bei A ausgelesen.

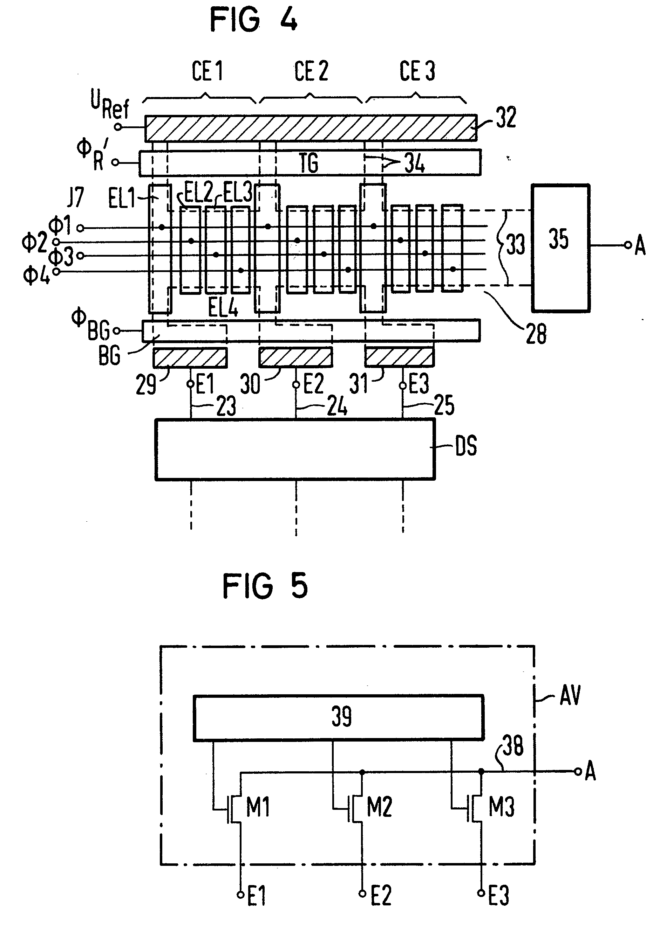

Die Auslesevorrichtung besteht zweckmäßigerweise aus einer CTD-Anordnung 28, die entsprechend Fig. 4 aufgebaut ist. Sie weist eine Reihe von auf der Isolierschicht 1b angeordneten Transferelektroden auf, von denen jeweils vier aufeinanderfolgende Elektroden, die mit Taktimpulsspannungen $\Phi 1$ bis $\Phi 4$ beschaltet sind, ein CTD-Element bilden. In Fig. 4 sind drei CTD-Elemente CE1 bis CE3 dargestellt. Jeweils eine Transferelektrode jedes Elements ist nach beiden Seiten verlängert und dabei einerseits einem Gate BG und andererseits einem Gate TG angenähert, die beide auf der Isolierschicht 1b

angeordnet und über die dargestellten Anschlüsse mit Taktimpulsspannungen $\Phi_{BG}$ und $\Phi_R'$ beschaltet sind. Neben dem Gate BG befinden sich drei mit den Eingängen E1 bis E3 verbundene Halbleitergebiete 29 bis 31, die zum Halbleiterkörper 1 entgegengesetzte Leitfähigkeit haben. Negen dem Gate TG ist ein Halbleitergebiet 32 vorgesehen, das ebenfalls eine zu 1 entgegengesetzte Leitfähigkeit aufweist und über den dargestellten Anschluß mit der Spannung $U_{Ref}$ beschaltet ist. Die gestrichelt eingezeichneten Linien 33 und 34 stellen die Begrenzungen von zwischen ihnen liegenden Dünnschichtbereichen der Isolierschicht 1b dar, die von Dickschichtbereichen umgeben sind. Eine CTD-Ausgangsstufe 35 ist mit dem Ausgang A beschaltet.

Bei einer Ausführung der erfindungsgemäßen Schaltung nach Fig. 4 wird die aus den Transistoren S1 bis S3 bestehende Rücksetzeinrichtung durch die Schaltungsteile TG und 32 in Verbindung mit den übrigen Schaltungsteilen der CTD-Anordnung 28 ersetzt. Es besteht aber andererseits die Möglichkeit, die Teile TG und 32 in Fig. 4 wegzulassen und die in Fig. 1 prinzipiell dargestellte Rücksetzvorrichtung beizubehalten.

Das Auslesen der korrigierten Sensorsignale geht bei einer gemäß Fig. 4 ausgebildeten Auslesevorrichtung so vor sich, daß beispielsweise bei einem am Eingang E1 anliegenden Spannungssignal $U_a$ beim Auftreten des Taktimpulses $\Phi_{BG1}$ (Fig. 3) eine von $U_a$ abhängige Ladungsmenge über eine durch die Amplitude von $\Phi_{BG}$ gegebene Potentialbarriere unterhalb von BG unter die Transferelektrode EL1 gelangt. Daher ergibt sich ein entsprechender Spannungsanstieg 36 an der Kondensatorelektrode 17. Es schließt sich dann der Weitertransport dieser in CE1 eingelesenen Ladungsmenge und der analog in die anderen CTD-Elemente eingelesenen Ladungsmengen durch das Anschalten der Taktimpulsspannungen $\Phi1$ bis $\Phi4$ an, was in Fig. 3 durch die Zeitspanne ZD und durch schmale Impulse $\Phi1$ angedeutet ist. Bis zum Beginn dieses Weitertransports liegt ein Spannungssignal $\Phi11$ am Anschluß J7 der CTD-Anordnung 28.

Schließlich wird durch einen Impuls $\Phi_{T22}$ die im Kondensator Ko1 befindliche Nullsignalladung in das Gebiet 21 abgeleitet, was an der Elektrode 17 zu einem Spannungsanstieg 36a führt.

Zu Beginn des nächsten Auslesevorgangs, der in Fig. 3 mit AL2 bezeichnet ist, wird die Elektrode 17 durch den Impuls $\Phi_{R2}'$ und gegebenenfalls $\Phi_{BG2}$ wieder auf die Spannung $U_{Ref}$ rückgesetzt.

In Fig. 5 ist eine andere Ausführungsform der Auslesevorrichtung AV schematisch dargestellt. Es handelt sich hierbei um eine Ausleseleitung 38, die z. B. aus einem metallischen oder aus hochdotiertem polykristallinem Silizium gebildeten Streifen bestehen kann oder auch als ein umdotierter, streifenförmiger Halbleiterbereich (Diffusionsleitung) ausgeführt sein kann. Die Eingänge E1 bis E3 sind über die Source-Drain-Strecken von Multiplex-Transistoren M1 bis M3 mit der Ausleseleitung 38 verbunden, wobei die Gates von M1 bis M3 an die Ausgänge einer Auswahlvorrichtung 39, z. B. eines Adreßdekoders oder eines digitalen Schieberegisters, geschaltet sind, die die Multiplex-Transistoren jeweils einzeln nacheinander in den leitenden Zustand schaltet.

Bei den behandelten Ausführungsbeispielen, bei denen von einem p-leitenden Halbleiterkörper ausgegangen wird, weisen die angegebenen Potentiale und Spannungen gegenüber dem Bezugspotential der Schaltung, auf dem der Halbleiterkörper 1 liegt, jeweils positive Vorzeichen auf. Werden die Leitfähigkeitstypen der einzelnen Halbleitergebiete durch die jeweils entgegengesetzten ersetzt, so kehren sich auch die Vorzeichen der Spannungen und Potentiale um.

Obwohl die CTD-Anordnung des angegebenen Ausführungsbeispiels als SCCD-Anordnung (Surface-Charge-Coupled Device) ausgebildet ist, kann die Erfindung mit bekannten CTD-Anordnungen beliebiger Art ausgeführt werden, wie sie z. B. in dem Buch von Sequin und Tompsett »Charge Transfer Devices«, Academic Press, New York, 1975 auf den Seiten 1 bis 18 beschrieben sind. Die CTD-Anordnungen können dabei entsprechend ihrem Aufbau nach einem der bekannten Verfahren, so z. B. im 2-, 3-, 4- oder Mehrphasenbetrieb, arbeiten.

Der in Fig. 3 mit ZD bezeichnete Zeitabschnitt stellt die Zeilendauer dar. In dieser Zeitspanne werden die von einer Sensorzeile stammenden Sensorsignale unter dem Einfluß der Taktimpulsspannungen $\Phi1$ bis $\Phi4$ am Ausgang A abgegeben. Die gleiche Zeitspanne benötigt ein durch die weiterverarbeiteten Sensorsignale gesteuerter Elektronenstrahl eines Bildsichtgerätes, um eine Bildzeile zu schreiben. Der Zeitabschnitt AL1 wird als Austastlücke bezeichnet. In diesem Zeitabschnitt wird ein das Zeilensignal in einem Wiedergabegerät schreibender Elektronenstrahl ausgetastet und vom Zeilenende zum Zeilenanfang der nächsten Zeile hingeführt. Für eine Wiedergabe in Fernsehgeräten müssen die Zeitabschnitte ZD und AL der Fernsehnorm entsprechen und betragen jeweils 52 µs und 12 µs.

## Patentansprüche

1. Monolithisch integrierter, zweidimensionaler Bildsensor, bei dem die Sensorelemente (2) auf einem dotierten Halbleiterkörper (1) in Zeilen (10) und Spalten (13) angeordnet sind, bei dem jeder Spalte eine Spaltenleitung (13) zugeordnet ist, die eine Ausleseleitung für die Sensorsignale der in dieser Spalte liegenden Sensorelemente darstellt, bei dem jede Spaltenleitung einem Eingang $(E_1)$ einer Auslesevorrichtung (AV) zugeordnet ist, an deren Ausgang (A) die Sensorsignale einer Zeile sequentiell auslesbar sind, und bei dem eine die gestörten Sensorsignale einer Sensorzeile gegenüber den sensoreigenen Störsignalen (Nullsignale) auswertende, differenzbildende Stufe (DS) vorgesehen ist, dadurch gekennzeichnet, daß die differenzbildende Stufe (DS) aus einer Anzahl von den Spaltenleitungen (13) individuell zugeordneten MIS-Kondensatoren (Ko1) besteht, deren äußere Elektroden (17) mit den Eingängen (E1) der Auslesevorrichtung (AV) verbunden und über eine Rücksetzvorrichtung ($S_1$) an eine Referenzspannung anschaltbar sind, und daß neben den äußeren Elektroden (17) zwei Gates (T1; T2) vorgesehen sind, von denen das erste (T1) einen Halbleiterbereich überdeckt, der zwischen den MIS-Kondensatoren (Ko1) und mit den Spaltenleitungen (13) verbundenen, umdotierten Halbleitergebieten (15) liegt, während das zweite (T2) einen zwischen den MIS-Kondensatoren (Ko1) und einem mit einer festen Betriebsspannung ($V_{DD}$) beschalteten, umdotierten Halbleitergebiet (21) liegenden Halbleiterbereich überdeckt.

2. Bildsensor nach Anspruch 1, dadurch gekennzeichnet, daß die Auslesevorrichtung (AV) eine CTD-Anordnung (28) enthält, die in CTD-Elementen, die den Spaltenleitungen (13) individuell zugeordnet sind, Transferelektroden (EL1) aufweist, welche in Richtung auf ein drittes Gate (BG) verlängert sind, und daß das dritte Gate (BG) neben umdotierten Halbleitergebieten (29, 30, 31) liegt, die mit den äußeren Elektroden (17) verbunden sind.

3. Bildsensor nach Anspruch 2, dadurch gekennzeichnet, daß die in Richtung auf das dritte Gate (BG) verlängerten Transferelektroden (EL1) auch in Richtung auf ein viertes Gate (TG) verlängert sind, das den Halbleiterbereich zwischen der CTD-Anordnung (28) und einem umdotierten, mit einer Referenzspannung ($U_{Ref}$) beschalteten Halbleitergebiet (32) überdeckt.

4. Bildsensor nach Anspruch 1, dadurch gekennzeichnet, daß die Auslesevorrichtung (AV) eine Ausleseleitung (38) enthält, an die die Eingänge (E1 . . . E3) der Auslesevorrichtung (AV) über Multiplex-Transistoren (M1 . . . M3) einzeln anschaltbar sind und daß die Gates der Multiplex-Transistoren (M1 . . . M3) mit den Ausgängen einer Auswahl-Vorrichtung (39) verbunden sind.

5. Verfahren zum Betrieb eines Bildsensors nach Anspruch 1, dadurch gekennzeichnet, daß von den gestörten Sensorsignalen einer Zeile (10) abgeleitete, erste Ladungsmengen über die Spaltenleitungen (13) parallel in die Kondensatoren (Ko1) eingelesen werden, deren äußere Elektroden (17) dabei auf einer Referenzspannung liegen, daß diese ersten Ladungsmengen nach dem Abschalten der äußeren Elektroden (17) von der Referenzspannung aus den Kondensatoren (Ko1) ausgelesen werden, daß anschließend von den Nullsignalladungen derselben Zeile (10) abgeleitete, zweite Ladungsmengen in die Kondensatoren (Ko1) eingelesen werden, daß die sich hierbei an den äußeren Elektroden (17) einstellenden Spannungen parallel der Auslesevorrichtung (AV) zugeführt werden, aus der sie dann sequentiell ausgelesen werden, und daß die zweiten Ladungsmengen aus den Kondensatoren (Ko1) ausgelesen werden.

6. Verfahren zum Betrieb eines Bildsensors nach Anspruch 2 oder 3, dadurch gekennzeichnet, daß von den gestörten Sensorsignalen einer Zeile (10) abgeleitete, erste Ladungsmengen über die Spaltenleitungen (13) parallel in die Kondensatoren (Ko1) eingelesen werden, deren äußere Elektroden (17) dabei auf einer Referenzspannung liegen, daß diese ersten Ladungsmengen nach dem Abschalten der äußeren Elektroden (17) von der Referenzspannung aus den Kondensatoren (Ko1) ausgelesen werden, daß anschließend von den Nullsignalladungen derselben Zeile (10) abgeleitete, zweite Ladungsmengen in die Kondensatoren (Ko1) eingelesen werden, daß von den sich hierbei an den äußeren Elektroden (17) einstellenden Spannungen Ladungen abgeleitet werden, die in die Elemente einer als Auslesevorrichtung dienenden CTD-Anordnung (28) eingegeben werden.

7. Verfahren nach Anspruch 6, dadurch gekennzeichnet, daß vor dem Einlesen der ersten und zweiten Ladungsmengen in die Kondensatoren (Ko) ein Rücksetzen der äußeren Elektroden (17) über die geöffneten dritten und vierten Gates auf ein Potential erfolgt, das von der Amplitude einer dem dritten Gate (BG) zugeführten Spannung abhängig ist, die diesem auch beim Auslesen der Ladungen in die Elemente der CTD-Anordnung (28) anliegt.

**Claims**

1. A monolithic, integrated, two-dimensional image sensor, wherein the sensor elements (2) are arranged on a doped semiconductor body (1) in rows (10) and columns (13), each column is assigned a column line (13) which represents a read-out line for the sensor signals of the sensor elements located in this column, each column line is assigned to an input ($E_1$) of a read-out device (AV) from whose output (A) the sensor signals of a row can be read out in sequential form, and wherein a stage (DS) serves to analyse the faulty sensor signals of a sensor row in relation to the sensor-specific interference signals (zero signals) and possesses a difference-forming function, characterised in that the difference-forming stage (DS) consists of a number of MIS capacitors (Ko1) which are individually assigned to the column lines (13) and whose outer electrodes (17) are connected to the inputs (E1) of the read-out device (AV) and can be connected via a reset device ($S_1$) to a reference voltage, and that in addition to the outer electrodes (17) two gates (T1; T2) are provided, the first (T1) of which covers a semiconductor zone which extends between the MIS capacitors (Ko1) and redoped semiconductor zones (15) connected to the column lines (13), whereas the second (T2) covers a semiconductor zone which extends between the MIS capacitors (Ko1) and a redoped semiconductor zone (21) which is connected to a fixed operating voltage ($V_{DD}$).

2. An image sensor as claimed in Claim 1, characterised in that the read-out device (AV) contains a CTD arrangement (28) which comprises, in CTD elements individually assigned to the column lines (13), transfer electrodes (EL1) extended in the direction of a third gate (BG), and in that the third gate (BG) is arranged beside redoped semiconductor zones (29, 30, 31) connected to the outer electrodes (17).

3. An image sensor as claimed in Claim 2, characterised in that those transfer electrodes (EL1) which are extended in the direction of the third gate (BG) are similarly extended in the direction of a fourth gate (TG) which covers the semiconductor zone between the CTD arrangement (28) and a redoped semiconductor zone (32) connected to a reference voltage ($U_{Ref}$).

4. An image sensor as claimed in Claim 1, characterised in that the read-out device (AV) contains a read-out line (38) to which the inputs (E1 ... E3) of the read-out device (AV) can be individually connected via multiplex transistors (M1 ... M3), and in that the gates of the multiplex transistors (M1 ... M3) are connected to the outputs of a selector device (39).

5. A process for the operation of an image sensor as claimed in Claim 1, characterised in that first quantities of charge derived from the faulty sensor signals of a row (10) are input via the column lines (13) in parallel into the capacitors (Ko1) whose outer electrodes (17) are at this time connected to a reference voltage, in that following the disconnection of the outer electrodes (17) from the reference voltage these first quantities of charge are read out from the capacitors (Ko1), in that second quantities of charge subsequently derived from the zero signal charges of the same row (10) are input into the capacitors (Ko1), in that the voltages now present on the outer electrodes (17) are fed in parallel fashion to the read-out device (AV), from which they are then read out in sequential form, and in that the second quantities of charge are read out from the capacitors (Ko1).

6. A process for the operation of an image sensor as claimed in Claim 2 or 3, characterised in that first quantities of charge derived from the faulty sensor signals of a row (10) are injected via the column lines (13) in parallel into the capacitors (Ko1), whose outer electrodes (17) are connected at this time to a reference voltage, in that following the disconnection of the outer electrodes (17) from the reference voltage these first quantities of charge are read out from the capacitors (Ko1), in that second quantities of charge subsequently derived from the zero signal charges of the same row (10) are injected into the capacitors (Ko1), in that charges are derived from the voltages now present at the outer electrodes (17) and are injected into the elements of a CTD arrangement (28) which serves as read-out device.

7. A process as claimed in Claim 6, characterised in that prior to the injection of the first and second quantities of charge into the capacitors (Ko), the outer electrodes (17) are reset via the open third and fourth gates to a potential dependent upon the amplitude of a voltage applied to the third gate (BG), which voltage is also applied thereto when the charges are read out into the elements of the CTD arrangement (28).

**Revendications**

1. Analyseur d'image bidimensionnel intégré monolithiquement, dans lequel les éléments détecteurs (2) sont disposés en lignes (10) et en colonnes (13) sur un corps semiconducteur dopé (1), dans lequel à chaque colonne est associé un conducteur de colonne (13) qui constitue un conducteur de lecture pour les signaux des éléments détecteurs se trouvant dans cette colonne, dans lequel à chaque conducteur de colonne est associée une entrée d'un dispositif de lecture (AV) sur la sortie (A) duquel les signaux des éléments détecteurs d'une ligne peuvent être lus séquentiellement, et dans lequel il est prévu un étage de formation de différence (DS) évaluant les signaux perturbés d'une ligne d'éléments détecteurs par rapport aux signaux perturbateurs (signaux zéro) propres aux éléments détecteurs, caractérisé par le fait que l'étage de formation de différence (DS) est constitué par un certain nombre de condensateurs MIS (Ko1) associés individuellement aux conducteurs de colonne (13), dont les électrodes extérieures (17) sont reliées aux entrées (E1) du dispositif de lecture (AV) et peuvent être raccordées, par l'intermédiaire d'un dispositif de remise dans l'état initial (S1), à une tension de référence, et qu'à côté des électrodes extérieures (17) sont prévues deux portes (T1, T2), dont la première (T1) recouvre une région conductrice qui se trouve entre les condensateurs MIS (Ko1) et des régions semiconductrices (15) non dopées et reliées aux conducteurs de colonne (13), tandis que la seconde (T2) recouvre une région semiconductrice se trouvant entre les condensateurs MIS (Ko1) et une région semiconductrice (21) non dopée et recevant une tension de foncitonnement fixe ($V_{DD}$).

2. Analyseur d'image suivant la revendication 1, caractérisé par le fait que le dispositif de lecture (AV) comporte un dispositif CTD (28) qui comprend, dans des éléments CTD qui sont associés individuellement aux conducteurs de colonne (13), des électrodes de transfert (EL1) qui sont prolongées en direction d'une troisième porte (EG), et que la troisième porte (BG) se trouve à côté de régions semiconductrices non dopées (29, 30, 31) qui sont reliées aux électrodes extérieures (17).

3. Analyseur d'image suivant la revendication 2, caractérisé par le fait que les électrodes de transfert (EL1), prolongées en direction de la troisième porte (BG), sont également prolongées en direction d'une quatrième porte (TG) qui recouvre la région semiconductrice entre le dispositif CTD (28) et une région semiconductrice (32) non dopée et reliée à une tension de référence (U$_{Ref}$).

4. Analyseur d'image suivant la revendication 1, caractérisé par le fait que le dispositif de lecture (AV) comporte un conducteur de lecture (38) auquel peuvent être reliées individuellement les entrées (E1 ... E3) du dispositif de lecture (AV), par l'intermédiaire de transistors multiplex (M1 ... M3), et que les portes des transistors multiplex (M1 ... M3) sont reliées aux sorties d'un dispositif de sélection (39).

5. Procédé pour la mise en oeuvre d'un analyseur d'image suivant la revendication 1, caractérisé par le fait que des premières quantités de charges dérivées des signaux perturbés des éléments détecteurs d'une ligne (10) sont introduits en parallèle, par l'intermédiaire des conducteurs de colonne (13), dans les condensateurs (Ko1) sont des électrodes extérieures (17) se trouvent ce faisant à une tension de référence, qu'après avoir supprimé la tension de référence des électrodes extérieures (17), ces premières quantités de charges sont lues à partir des condensateurs (Ko1), qu'ensuite des secondes quantités de charges dérivées des charges de signaux zéro de la même ligne (10), sont introduites dans les condensateurs (Ko1), que les tensions s'établissant de ce fait sur les électrodes extérieures (17) sont amenées en parallèle au dispositif de lecture (AV), à partir duquel elles sont alors lues séquentiellement, et que les secondes quantités de charges sont lues à partir des condensateurs (Ko1).

6. Procédé pour la mise en oeuvre d'un analyseur d'image suivant la revendication 2 ou 3, caractérisé par le fait que des premières quantités de charges, dérivées des signaux perturbés des éléments détecteurs d'une ligne (10), sont introduites en parallèle, par l'intermédiaire des conducteurs de colonne (13), dans les condensateurs (Ko1) dont des électrodes extérieures (17) se trouvent ce faisant à une tension de référence, qu'après avoir supprimé la tension de référence des électrodes extérieures (17), ces premières quantités de charges sont lues à partir des condensateurs (Ko1), qu'ensuite des secondes quantités de charges dérivées des charges de signaux zéro de la même ligne (10), sont introduites dans les condensateurs (Ko1), qu'à partir des tensions s'établissant de ce fait sur les électrodes extérieures (17) sont dérivées des charges qui sont introduites dans les éléments d'un dispositif CTD (28) servant de dispositif de lecture.

7. Procédé suivant la revendication 6, caractérisé par le fait qu'avant l'introduction des première et seconde quantités de charges dans les condensateurs (Ko), les électrodes extérieures (17) sont remises, par l'intermédiaire des troisième et quatrième portes ouvertes, à un potentiel qui dépend de l'amplitude d'une tension appliquée à la troisième porte (BG) et qui lui est également appliquée lors de la lecture des charges dans les éléments du dispositif CTD (28).

# FIG 1

# FIG 2

# FIG 3

# FIG 4

# FIG 5